# EUROPÄISCHE PATENTSCHRIFT

(11) **EP 0 801 726 B1**
(45) Veröffentlichungstag und Bekanntmachung des Hinweises auf die Patenterteilung: **25.07.2001**
(21) Anmeldenummer: 95929717.7
(22) Anmeldetag: 25.08.1995
(51) Int. Cl.: G01J 1/44, H04B 10/06

(54) **SCHALTUNG ZUM EINSTELLEN DES ARBEITSPUNKTES EINES OPTOELEKTRONISCHEN ELEMENTS**
CIRCUIT FOR SETTING THE OPERATING POINT OF AN OPTO-ELECTRONIC COMPONENT
CIRCUIT PERMETTANT D'AJUSTER LE POINT DE FONCTIONNEMENT DYNAMIQUE D'UN ELEMENT OPTOELECTRONIQUE

(30) Priorität: 01.09.1994 DE 4431117
(43) Veröffentlichungstag der Anmeldung: 22.10.1997
(73) Patentinhaber: Reime, Gerd, D-75328 Schömberg (DE)
(72) Erfinder: Reime, Gerd, D-75328 Schömberg (DE)
(74) Vertreter: Reinhardt, Harry
(86) Internationale Anmeldenummer: DE9501150
(87) Internationale Veröffentlichungsnummer: WO9607084

(56) Entgegenhaltungen:
- DE-A- 3 233 728
- DE-C- 3 930 415
- RESEARCH DISCLOSURE, Bd. 270, Nr. 066, 10.Oktober 1986 EMSWORTH, GB, ANONYMOUS 'Photodiode zero bias circuit - has PNP current mirror and NPN current mirror to maintain zero voltage difference'

## Beschreibung

### GEBIET DER ERFINDUNG

Die Erfindung betrifft eine Schaltung zum Einstellen des Arbeitspunktes einer Photodiode nach dem Oberbegriff des Anspruches 1.

### STAND DER TECHNIK

Eine derartige Schaltung ist z. B. aus der DE-C 39 30 415 bekannt und wird eingesetzt, um Änderungen im Lichteinfall zu messen und daraus verwertbare Signale zu erhalten. Da grundsätzlich zwischen der Beleuchtungsstärke und der Leerlaufspannung bei einer Photodiode ein logarithmischer Zusammenhang besteht, ergibt sich bei zunehmender Beleuchtung eine schnell erreichte Sättigungsspannung, die je nach verwendeter Photodiode bei ca. 0,5 V erreicht ist. Oberhalb dieser Sättigungsspannung besteht ein linearer Zusammenhang zwischen Beleuchtungsstärke und Photostrom über viele Zehnerpotenzen hinweg. Will man nun Wechsellicht-Nutzsignale, die von Gleichlicht überlagert sind, in eine Signalspannung umwandeln, ist es erforderlich, die Photodiode in einem Bereich unterhalb dieser Sättigungsspannung zu betreiben, um überhaupt einen Signalverlauf erkennen zu können und somit den Arbeitspunkt einzustellen.

In der DE-C 39 30 415 wird hierzu eine Kompensationsspannung mittels einer zweiten Photodiode erzeugt, ohne daß Strom aus der Versorgungsspannung benötigt wird. Die Spannung dieser zweiten Photodiode wird als Gegen- oder Fremdspannung der eigentlichen Photodiode über eine Spule mit einem konstanten Innenwiderstand zugeführt. Somit sind zunächst zwei Photodioden erforderlich, von denen nur eine aktiv das Wechsellicht empfängt. Damit jedoch eine Kompensation der Photospannung durch eine von der zweiten Photodiode erzeugte gleichartige Spannung erfolgen kann, müssen beide Photodioden gleichmäßig beleuchtet werden, was nicht immer gewährleistet ist. Zur Lösung dieses Problems wird vorgeschlagen, die Störsignal-Photodiode größer auszubilden als die Nutzsignal-Photodiode, was die Schaltung verteuert. Variiert wird hier die Spannung, während der Widerstand unverändert bleibt. Die Verwendung einer Spule als Gleichstrompfad hat zudem den Nachteil, daß diese Schaltung nicht in einem IC (integrated circuit) integrierbar ist. Gerade diese Integration wird zudem hier auch dadurch erschwert, daß aufgrund des dem Störsignal-Photosensor parallel geschalteten Kondensators eine Schaltung auf einen symmetrischen Eingang nicht möglich ist.

Um die Photodiode unterhalb der Sättigungsspannung zu halten, ist es ferner bekannt, die Photodiode im Diodenbetrieb mit Vorspannung zu betreiben. Dabei wird eine Vorspannung an die Diode gelegt, um sie zu sperren (entgegengesetzte Polung zur Sättigungsspannung). Alternativ kann die Diode auch im Elementbetrieb ohne Vorspannung betrieben werden. Hier wirkt die Photodiode als Stromquelle. Die Photodiode wird dazu auf einem Null-Potential gehalten, während der Photostrom über einen Widerstand kompensiert wird.

Beide Betriebsweisen, also Dioden- bzw. Elementenbetrieb haben gemeinsam, daß sie eine externe Stromquelle brauchen, um den bei Beleuchtung auftretenden Photostrom zu kompensieren. Je nach Diodenart und Beleuchtung kann dieser Kompensationsstrom einige zig µA bis einige mA betragen. Dieser Strom muß aus der Versorgungsspannung entnommen werden, was insbesondere bei Batteriebetrieb zu einem schnellen Erliegen der Batterie führt. Unter Umständen kann dieser aus der Batterie zu entnehmende Strom das Mehrfache des Stromes sein, den die gesamte Schaltung aufnimmt.

Aus der DE-A 32 33 728 ist eine Schaltungsanordnung zur Unterdrückung von Gleichlichtsignalkomponenten in einem Vorverstärker für einen Infrarotlicht-Empfänger mit einer Photodiode bekannt, deren Arbeitspunkt durch einen in Reihe geschalteten Widerstand festgelegt ist. Um die Stromaufnahme der Photodiode gering zu halten und eine wirksame Gleichlichtunterdrückung bei der Signalverarbeitung sicherzustellen sowie eine hochohmige Eingangsstufe zu erreichen, ist parallel zum, den Arbeitspunkt der Photodiode bestimmenden, Widerstand eine vom Sperrstrom der Photodiode durchflossene Diode geschaltet und das empfangene Signal an einen in Bootstrap-Schaltung angeordneten Impedanzwandler angelegt, der gemeinsam mit einer nachfolgenden Verstärkerstufe wie eine Kaskadeschaltung arbeitet. Die Schaltungsanordnung kann damit zwar ohne Regelschleife den Lastwiderstand der Photodiode in Abhängigkeit der Gleichlichtkomponente verändern und dadurch das abgreifbare Nutzsignal von Gleichstromkomponenten befreien, jedoch ist immer noch eine zusätzliche Betriebsspannung erforderlich.

Die Erfindung eignet sich bevorzugterweise für den Einsatz in Verbindung mit einem batteriebetriebenen Wassersensor, wie er aus dem DE-U 93 09 837.5 bekannt ist. Ein batteriebetriebener Einsatz eines Wassersensors ist z.B. im Bereich des Bootsbaus erwünscht. Boote von "Freizeitkapitänen" besitzen in der Regel eine oder mehrere Schlafstellen im Bug unterhalb der Seitenschiebefenster. Oft wird nun vergessen, diese zu schließen, so daß Spritzwasser die Schlafstellen durchnäßt, ohne daß der Bootsführer es merkt. Wird hier in regelmäßigen Abständen eine Überprüfung der Fensterflächen auf Spritzwasser mittels des bekannten Wassersensors vorgenommen, können diese ggf. automatisch verschlossen werden. Ein anderer Einsatzbereich wäre z.B. ein an der Wäscheleine einer Hausfrau befestigbarer Wassersensor, der beim Auftreten von Regentropfen ein Signal abgibt. Auch hier ist es erforderlich, daß eine Überprüfung auf das Auftreten von Wassertropfen stattfindet. Derartige Geräte sind also von einer externen Stromversorgung grundsätzlich unabhängig, werden sie jedoch mit einem 9 V-Block betrieben, muß der Durchschnittsstromverbrauch klein gehalten werden. Ein Einsatz ist aber allgemein dort möglich, wo Wechsellicht-Nutzsignale erfaßt werden.

### OFFENBARUNG DER ERFINDUNG

Ausgehend von diesem Stand der Technik liegt der vorliegenden Erfindung daher die Aufgabe zugrunde, den infolge des Gleichlichtstromes notwendigen Kompensationsstrom ohne Fremdspannung so hervorzurufen, daß nahezu kein Strom aus der Stromversorgung oder Batterie entnommen werden muß.

Diese Aufgabe wird durch die Merkmale des Anspruches 1 gelöst.

Bei den optoelektronischen Elementen zum Empfang der Lichtsignale, gleichgültig ob Photodioden, Leuchtdioden oder Phototransistoren verwendet werden, steigt auch hier die Spannung logarithmisch mit der Beleuchtungsstärke an, bis bei z.B. 0,5 V die Sättigungsspannung erreicht wird. Im Bereich der Sättigungsspannung führt eine weitere Zunahme der Beleuchtungsstärke zu keinem weiteren Spannungsanstieg, d.h. eine kleine Wechsellichtkomponente (LED-Modulation) wirkt sich nicht auf die Ausgangsspannung aus. Nur im Bereich der Kennlinienkrümmung kann, sich eine Wechselspannung ausbilden. Aus diesem Grund muß die Spannung am optoelektronischen Element auf einem Wert unterhalb der Sättigungsspannung gehalten werden. Am einfachsten geschieht dies durch einen Lastwiderstand, der soviel Strom verbraucht, daß die Spannung am optoelektronischen Element z.B.immer die Hälfte der Sättigungsspannung beträgt. Dabei wird kein externer. Strom benötigt, allerdings muß der Widerstand ständig der Gleich- oder Umgebungslichtstärke angepaßt werden. Bei z.B. U/2 der Sättigungsspannung wird eine Wechsellichtkomponente immer auch eine Spannungsänderung am Widerstand hervorrufen.

Weitere Vorteile ergeben sich aus den Unteransprüchen.

### KURZBESCHREIBUNG DER ZEICHNUNGEN

- Fig. 1: eine Schaltung bei der einer Photodiode eine Germaniumdiode mit Lastwiderstand parallel geschaltet ist,
- Fig. 2: eine Schaltung, bei der zwei Photodioden eine Schottky- oder eine Silizium-Diode mit einem Lastwiderstand parallel geschaltet ist,
- Fig. 3: eine Schaltung, bei der einer Photodiode ein Feld-Effekt-Transistor parallel geschaltet ist,
- Fig. 4: eine Schaltung gemäß Fig. 2 mit symmetrischem Operationsverstärker,
- Fig. 5: eine Schaltung gemäß Fig. 1 mit einem symmetrischen Operationsverstärker,
- Fig. 6: eine Schaltung gemäß Fig. 2 mit einer asymmetrischen Verstärkerschaltung,
- Fig. 7: eine Schaltung, bei der zwischen zwei Photodioden ein regelbarer Feld-Effekt-Transistor zwischengeschaltet ist, der über einen Operationsverstärker regelbar ist,
- Fig. 8: eine Schaltung, bei der als optoelektronisches Element eine Leuchtdiode eingesetzt wird,

### BEVORZUGTE AUSFÜHRUNGSFORMEN DER ERFINDUNG

Die Schaltung dient zum Einstellen des Arbeitspunktes wenigstens eines optoelektronischen Elementes, wobei das optoelektronische Element Teil eines Empfängers von Wechsellichtnutzsignalen ist, denen Gleichlichtsignale überlagert sind. Als optoelektronisches Element können bekannte Photodioden 10,10',10", aber auch Leuchtdioden 110 dienen. Wesentlich ist lediglich die Eigenschaft als Empfänger dienen zu können, was auch bei einer Leuchtdiode grundsätzlich möglich ist. Alle Schaltungen haben jedoch das Problem, daß die optoelektronischen Elemente nur in einem bestimmten Bereich Wechsellichtsignale in nutzbare Ausgangssignale umwandeln können. Daher ist es erforderlich, den Arbeitspunkt dieser optoelektronischen Elemente unterhalb der Sättigungsspannung zu halten, was durch eine Widerstandsschaltung geschieht, die einen selbstregelnden Widerstand aufweist. In der Widerstandsschaltung wird der Widerstand spannungsabhängig und gegebenenfalls auch frequenzabhängig so geregelt, daß stets am optoelektronischen Element eine Spannung ansteht, die sich im Bereich einer vorzugsweise positiven Spannung unterhalb der Sättigungsspannung bewegt.

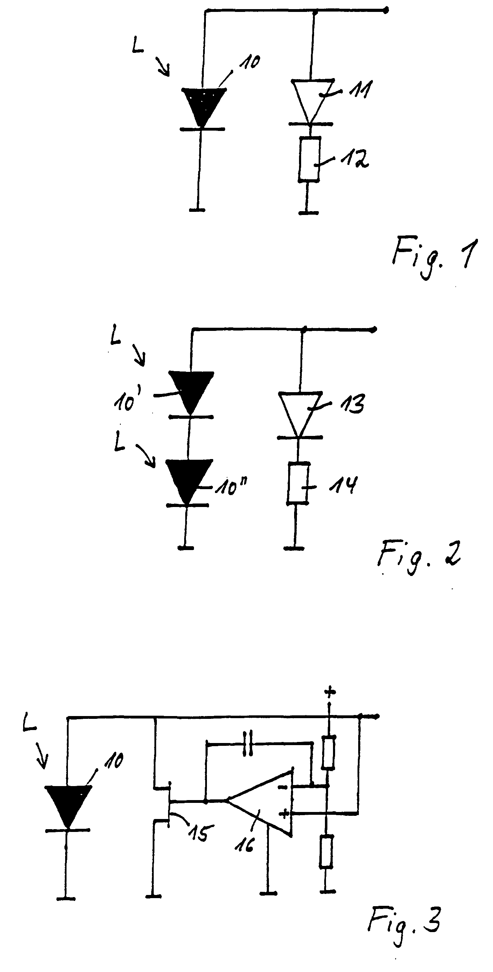

In den Figuren 1 bis 7 werden als optoelektronische Elemente Photodioden 10,10',10" und in Fig. 8 eine Leuchtdiode 110.

In Fig. 1 wird die Photodiode 10 einer Beleuchtung L ausgesetzt. Parallel zur Photodiode ist eine Diode 11, hier eine Germanium-Diode angeordnet. Mit dieser Germanium-Diode in Reihe geschaltet ist ein kleiner Lastwiderstand von etwa 10 Kiloohm. Bei steigender Spannung der Photodiode öffnet die Germaniumdiode bei etwa 0,3V, so daß die Photodiode nur dann belastet wird, wenn eine Photo-spannung > 0,3V auftritt. In diesem Fall kann dann die über-schüssige Spannung über den Widerstand 12 abgebaut werden, da sich der Innenwiderstand der Germaniumdiode in Abhängigkeit von der Photospannung ändert. Der Widerstand dient zur Verhinderung von Signalasymmetrien bei hohen Beleuchtungsstärken (Gleichrichter effekte). Der Nachteil dieser Schaltung ist, daß Germaniumdioden kaum noch verwendet werden, so daß sich hier eine relativ teuere Schaltung ergibt.

In Fig. 2 liefern bei Beleuchtung zwei Photodioden 10', 10" eine positive und negative Spannung von zusammen maximal 1V. Eine Schottky-Diode 13 (z.B. BAT 83) mit einer Durchlaßspannung von 0,4V begrenzt die Photospannung auf 0,2V je Photodiode. Das gleiche Ergebnis kann auch durch Einsatz einer Silizium-Diode (1N 41/48) mit einer Durchlaßspannung von etwa 0,6V erzielt werden. Vorteilhaft ist hierbei die doppelte Ausgangsspannung, nachteilig die Verwendung zweier Photodioden. Wie im Ausführungsbeispiel der Fig. 1 öffnet die Schottky-Diode 13 bei Erreichen der Durchlaßspannung, so daß der Widerstand 14 von z.B. 2 Kiloohm die überflüssige Photospannung abbauen kann. In den Ausführungsbeispielen der Fig. 1,2 kann aber auch auf die Widerstände 12,14 verzichtet werden, sofern der Innenwiderstand der Diode 11 bzw. der Schottky-Diode 13 ausreichend groß ist.

Im Ausführungsbeispiel der Fig. 3 wird der einer Beleuchtung L unterworfenen Photodiode 10 z.B. ein Feldeffekttransistor 15 oder zugeschaltet. Über einen Operationsverstärker 16 wird die Photodiodenspannung ständig mit einer Referenzspannung verglichen und mittels des Feld-Effekt-Transistors nachgeregelt. Der Feld-Effekt-Transistor arbeitet als variabler Widerstand. Dabei wird die Drain-Source bzw. der Kollektor-Emitter-Widerstand so geregelt, daß die Spannung am optoelektronischen Element unterhalb der Sättigungsspannung bleibt bzw. ungefähr der halben Sättigungsspannung entspricht. Die Vorteile dieser Schaltung bestehen darin, daß nur eine Photodiode erforderlich ist und zudem eine sehr genaue Regelung erfolgt. Nachteilig ist jedoch, daß der Operationsverstärker Strom benötigt; da hier jedoch bevorzugterweise
träge Operationsverstärker eingesetzt werden, benötigt der Operationsverstärker nur einen Strom von etwa 1,2 µA. Anstelle des Feldeffekttransistors 15 können beliebige bipolare Transistoren oder andere Halbleiterelemente eingesetzt werden. Letztere benötigen allerdings einen geringen Basisstrom.

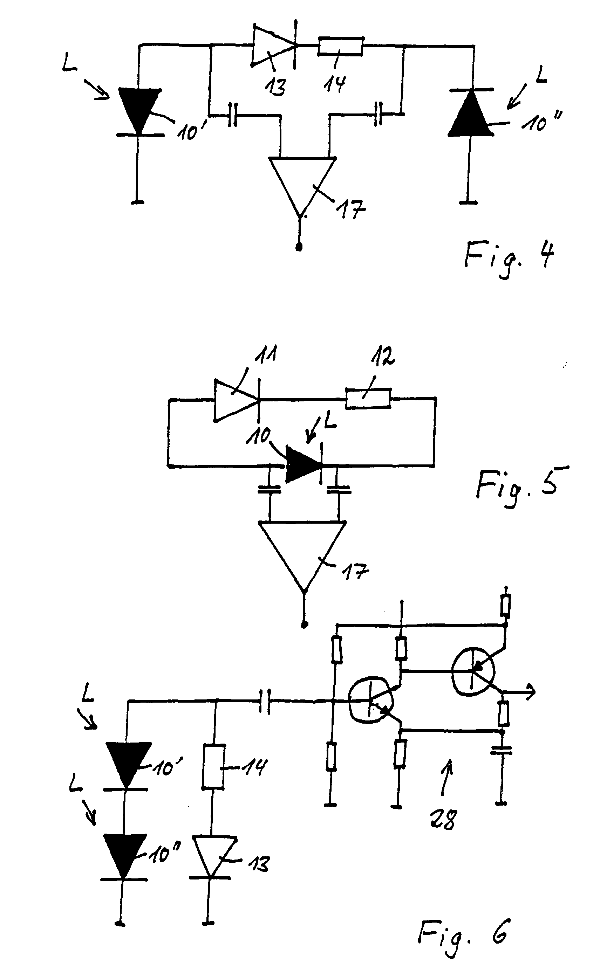

Die Schaltungen der Fign. 1-3 können auch mit einem symmetrischen Operationsverstärker betrieben werden. Dies ist für das Ausführungsbeispiel der Fig. 2 in Fig. 4 und für das Ausführungsbeispiel der Fig. 1 in Fig. 5 dargestellt. Der Operationsverstärker wird dabei als symmetrischer Verstärker zugeschaltet. Dadurch werden Gleichtaktstörungen unterdrückt. Der Operationsverstärker 17 ist über Kondensatoren parallel zu der Germaniumdiode 11 oder der Schottky-Diode 13 und den zugehörigen Widerständen 12, 14 geschaltet. Fig. 6 zeigt eine Vereinfachung der vorgenannten Schaltungen dadurch, daß ein unsymmetrischer Verstärker 28 verwendet wird.

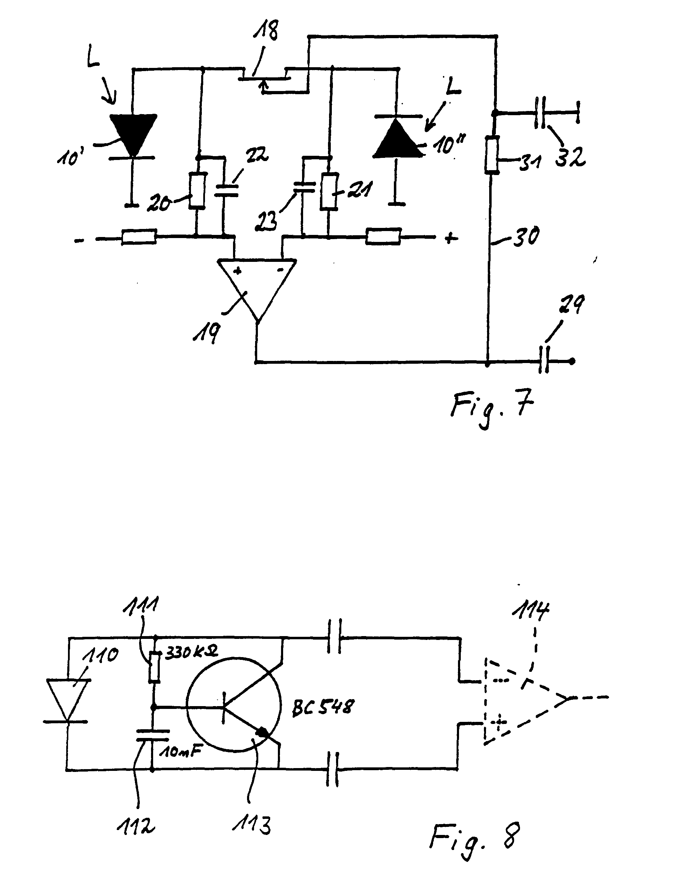

Eine optimale aber etwas teuere Lösung ist in Fig. 7 dargestellt. Zur Regelung des Photodiodenstromes wird ein Feld-Effekt-Transistor 18 in Reihe zwischen zwei gleichgepolten Photodioden 10', 10" angeordnet. Parallel zu dem Feld-Effekt-Transistor ist ein Operationsverstärker 19 angeordnet. Zwischen den Photodioden und dem Operationsverstärker sind Widerstände 20, 21 angeordnet, die über Kondensatoren 22, 23 überbrückt sind. Die Widerstände dienen nur zur Kompensation der positiven bzw. negativen Photospannung zum Operationsverstärker, so daß bei z.B. 0,2 V positiver Photospannung und 0,2 V negativer Photospannung immer 0 plus 0 V am Operationsverstärker anstehen. Damit kann der Operationsverstärker 19 über den Feld-Effekt-Transistor den Photodiodenstrom regeln. Die Kondensatoren 22, 23 dienen der Wechselspannungsüberbrückung, damit der Operationsverstärker 19 zusätzlich als erste Wechsellichtsignalverstärkerstufe eingesetzt werden kann. Über den Kondensator 29 wird der Gleichstrom-Anteil ausgekoppelt, während über die Leitung 30 die Regelung des Photodiodenstromes erfolgt. Durch die Bauelemente 31 und 32 erfolgt schließlich eine Wechselspannungsunterdrückung.

Alle Schaltungen haben gemeinsam, daß die Photodiode dynamisch belastet wird, ohne daß Strom in nennenswertem Umfang aus der Versorgung entnommen wird. Ohne Beleuchtung sind die Photodiode und, soweit vorhanden, die Belastungsdioden oder Widerstände hochohmig (bzw. hochohmige Stromquellen). Bei Beleuchtung werden die Photodiode als Generator sowie die Belastungsdioden oder Widerstände niederohmig, und zwar immer so, daß der Innenwiderstand der Photodioden durch einen gleich großen Innenwiderstand der Belastungsdioden oder Widerstände kompensiert wird. (Ausführungsbeispiele der Fign. 1, 2, 4, 5.) Dadurch wird ein Ausgangs-signal auch bei großem Fremdlichtanteil immer gewährleistet. Ohnehin ist das zur Erzeugung des Ausgangssignals zu erfassende Wechsellicht-Nutzsignal meist klein im Verhältnis zum Gleichlicht des Fremdlichts, gleichgültig um welchen Anwendungsbereich es sich bei den Nutzsignalen handelt.

In einer praktischen Anwendung hat sich herausgestellt, daß bei einer üblichen Beschaltung bei voller Sonneneinstrahlung ein Strom von 260 µA fließt, der durch eine Gegenspannung bzw. Strom kompensiert werden muß. Dieser Kompensationsstrom ist jedenfalls größer als bei Batterie-Dauerbetrieb möglich. Bei den genannten Ausführungsbeispielen (bei denen ein nachgeschalteter stromarmer Operationsverstärker die Aufgabe der Steuerspannungserzeugung für den Feld-Effekt-Transistor übernimmt sowie gleichzeitig der Wechselspannungsverstärkung dient) konnte bei hoher Empfindlichkeit ein Stromverbrauch mit diskretem Verstärker in C-Mos Technologie von 10 µA für den kompletten Wassersensor im Durchschnitt erreicht werden. Rechnet man den hohen Strom im wohl seltenen Alarmfall mit ein, so kann ein handelsüblicher 9 V-Block mehr als 2 Jahre halten.

Alternativ zu den Photodioden, jedoch zum gleichen Zweck, können auch Leuchtdioden eingesetzt werden. Gegenüber den bekannten Photodioden haben die Leuchtdioden den Vorteil, daß sie grundsätzlich günstiger zu beschaffen sind. Sie liefern als Sättigungsspannung zwischen 0,9 und 2 Volt und können mit einem einfachen bipolaren Transistor 113 belastet werden, der über einen Widerstand 111 und einen Kondensator 112 vorzugsweise an eine symmetrische Schaltung angekoppelt ist. Fig. 8 zeigt, daß der Transistor parallel zur Leuchtdiode 110 geschalten ist. Der Basispunkt des Transistors ist zwischen einem Widerstand 111 von 330 Kiloohm und einem Kondensator 112 von 10 nF angekoppelt. Die Basis-Kollektorstrecke steht dabei mit der Leuchtdiode 110 und die Basis-Emitterstrecke mit der Sperrseite der Leuchtdiode 110 in Verbindung. Als Transistor kann ein BC 548 eingesetzt werden. Da sich hier z.B. eine symmetrische Beschaltung ergibt, kann optional der gestrichelt dargestellte Operationsverstärker 114 vorgesehen werden.

Alternativ kann ferner das gleiche Ziel auch mit der Photodiodenstrecke eines Phototransistors erreicht werden, sofern man die Basis-Kollektorstrecke in den Regelkreis einbezieht. Allerdings wirkt diese Strecke des Phototransistors dann wiederum wie eine Photodiode.

Die Schaltungen haben allesamt den Vorteil, daß sie keine Spulen aufweisen und somit leicht in einen IC (Integrated Circuit) integrierbar sind. Außerdem können allesamt so aufgebaut werden, daß sie auf einen symmetrischen Eingang geschaltet werden können. Selbst wenn im Ausführungsbeispiel der Fig. 2 mehr als eine Photodiode als opto-elektronisches Element benötigt wird, so ist es dennoch nicht erforderlich, diese Photodioden kostenaufwendig unterschiedlich auszugestalten, da sie auch ungleichmäßig beleuchtet werden können, ohne die Funktion der Schaltung zu gefährden. Die Lastregelung erfolgt ausschließlich für Gleichlichtsignale, während Wechsellichtsignale bei der Lastregelung bewußt unterdrückt werden. Die verwendeten optoelektronischen Elemente Photodiode 10,10',10 " und Leuchtdiode 110 als auch die Basis-Kollektorstrecke des Phototransistors stellen optoelektronische Elemente dar, die im Kurzschlußbetrieb Strom und im Leerlaufbetrieb Spannung erzeugen. Wesentlicher Unterschied zwischen Leuchtdiode und Photodiode ist, daß die Leuchtdiode bei großer Spannung und kleinem Strom arbeitet, während die Photodiode bei großem Strom und kleiner Spannung arbeitet.

## Patentansprüche

1. Schaltung zum Einstellen des Arbeitspunktes wenigstens eines optoelektronischen Elements, das im Kurzschlußbetrieb Strom und im Leerlaufbetrieb Spannung erzeugt, wobei das optoelektronische Element Teil eines Empfängers von Wechsellicht-Nutzsignalen ist und die Schaltung den Arbeitspunkt unterhalb der Sättigungsspannung des optoelektronischen Elements mit einer parallel zum optoelektronischen Element geschalteten Widerstandsschaltung zumindest zur Kompensation von Gleichlichtsignalen einstellt, dadurch gekennzeichnet, daß die Widerstandsschaltung einen selbstregelnden Widerstand aufweist, der zumindest spannungsabhängig seinen Widerstand ändert, sobald eine bestimmte Spannung unterhalb der Sättigungsspannung überschritten ist und dadurch das optoelektronische Element belastet, bis die bestimmte Spannung im wesentlichen erreicht ist.

2. Schaltung nach Anspruch 1, dadurch gekennzeichnet, daß das optoelektronische Element wenigstens eine Photodiode (10,10',10") ist, die durch den selbstregelnden Widerstand belastet ist.

3. Schaltung nach Anspruch 2, dadurch gekennzeichnet, daß als selbstregelnder Widerstand der Photodiode (10) eine Diode (11), vorzugsweise eine Germaniumdiode parallel geschaltet ist, wobei die Schwellspannung der Diode (11) etwa der halben Sättigungsspannung der Photodiode (10) entspricht.

4. Schaltung nach Anspruch 3, dadurch gekennzeichnet, daß die Diode (11) mit einem Widerstand (12) in Reihe geschaltet ist.

5. Schaltung nach Anspruch 2, dadurch gekennzeichnet, daß zwei Photodioden (10', 10") eine Schottky-Diode (13) oder eine Silizium-Diode parallel geschaltet ist, wobei die Schwellspannung der Schottky-Diode oder der Silizium-Diode etwa der halben Sättigungsspannung der Photodioden entspricht.

6. Schaltung nach Anspruch 5, dadurch gekennzeichnet, daß die Schottky-Diode (13) oder die Silizium-Diode mit einem Widerstand (14) in Reihe geschaltet ist.

7. Schaltung nach Anspruch 2, dadurch gekennzeichnet, daß als selbstregelnder Widerstand wenigstens einer Photodiode (10) ein Feld-Effekt-Transistor (15) oder bipolarer Transistor parallel geschaltet ist, dessen Widerstand von einem Operationsverstärker (16) geregelt ist.

8. Schaltung nach Anspruch 2, dadurch gekennzeichnet, daß der wenigstens einen Photodiode (10; 10'; 10") und dem selbstregelnden Widerstand ein symmetrischer Operationsverstärker (17) zugeschaltet ist.

9. Schaltung nach Anspruch 2, dadurch gekennzeichnet, daß zur Regelung des Photodiodenstroms ein Feld-Effekt-Transistor (18) in Reihe zwischen zwei gleichgepolten Photodioden (10', 10") angeordnet ist, der über einen parallel geschalteten Operationsverstärker (19) regelbar ist, dem an beiden Eingängen zur Kompensation der Photospannung Widerstände (20, 21) vorgeschaltet sind.

10. Schaltung nach Anspruch 1, dadurch gekennzeichnet, daß das optoelektronische Element zum Empfang der Lichtsignale eine Leuchtdiode (110) ist.

11. Schaltung nach Anspruch 10, dadurch gekennzeichnet, daß der Leuchtdiode (110) ein bipolarer Transistor (113) zur Belastung parallel geschaltet ist.

## Claims

1. Circuit for adjusting the operating point of at least one optoelectronic element, which generates current during the short-circuit operation and voltage during the no-load operation, wherein the optoelectronic element constitutes a component of a receiver for alternating light wanted signals and wherein the circuit adjusts the operating point below the saturation voltage of the optoelectronic element with a resistive circuit connected parallel to the optoelectronic element, at least for the compensation of constant light signals,
characterized in that the resistive circuit comprises an automatic control resistor which changes its resistance at least depending on the voltage, as soon as a specific voltage below the saturation voltage is exceeded, and thus stresses the optoelectronic element, until the specific voltage is essentially reached.

2. Circuit according to Claim 1, characterized in that the optoelectronic element is at least one photodiode (10, 10', 10") that is stressed by the automatic control resistor.

3. Circuit according to Claim 2, characterized in that a diode (11), preferably a germanium diode, is parallel connected to the photodiode (10) as automatic control resistor, wherein the threshold voltage for the diode (11) corresponds to about half the saturation voltage for the photodiode (10).

4. Circuit according to Claim 3, characterized in that the diode (11) is connected in series with a resistor (12).

5. Circuit according to Claim 2, characterized in that one Schottky diode (13) or one silicon diode is parallel-connected to two photodiodes (10', 10"), wherein the threshold voltage for the Schottky diode or the silicon diode corresponds to about half the saturation voltage of the photodiodes.

6. Circuit according to Claim 5, characterized in that the Schottky diode (13) or the silicon diode is connected in series with a resistor (14).

7. Circuit according to Claim 2, characterized in that a field effect transistor (15) or bipolar transistor is parallel-connected as automatic control resistor to at least one photodiode (10), the resistance of which transistor is controlled by an operational amplifier (16).

8. Circuit according to Claim 2, characterized in that a symmetric operational amplifier (17) is added to the at least one photodiode (10; 10'; 10") and the automatic control resistor.

9. Circuit according to Claim 2, characterized in that for controlling the photodiode current, a field effect transistor (18) is arranged in series between two unipolar photodiodes (10', 10"), which can be controlled via a parallel-connected operational amplifier (19), which has in series connected resistors (20, 21) at the two inputs, designed to compensate for the photoelectric voltage.

10. Circuit according to Claim 1, characterized in that the optoelectronic element for receiving the light signals is a light-emitting diode (110).

11. Circuit according to Claim 12, characterized in that a bipolar transistor (113) is parallel-connected as load to the light-emitting diode (113).

## Revendications

1. Circuit permettant de régler le point de fonctionnement dynamique d'au moins un élément optoélectronique qui en mode court-circuit produit un courant et en mode à vide, une tension, l'élément optoélectronique faisant partie d'un récepteur de signaux utiles de lumière alternative, et le circuit réglant le point de fonctionnement au-dessous de la tension de saturation de l'élément optoélectronique avec un circuit à résistance, monté en parallèle avec l'élément optoélectronique, au moins pour la compensation de signaux de lumière continue, caractérisé en ce que le circuit à résistance comporte une résistance à auto-régulation qui fait varier sa résistance au moins en fonction de la tension dès qu'une tension déterminée inférieure à la tension de saturation est dépassée et de ce fait, sollicite l'élément optoélectronique jusqu'à ce que la tension déterminée soit sensiblement atteinte.

2. Circuit selon la revendication 1, caractérisé en ce que l'élément optoélectronique est au moins une photodiode (10, 10', 10") qui est sollicitée par la résistance à auto-régulation.

3. Circuit selon la revendication 2, caractérisé en ce qu'une diode (11), de préférence une diode au germanium, est montée en parallèle à la photodiode (10), en tant que résistance à auto-régulation, la tension seuil de la diode (11) correspondant approximativement à la moitié de la tension de saturation de la photodiode (10).

4. Circuit selon la revendication 3, caractérisé en ce que la diode (11) est montée en série avec une résistance (12).

5. Circuit selon la revendication 2, caractérisé en ce qu'une diode Schottky (13) ou une diode au silicium est montée en parallèle à deux photodiodes (10', 10"), la tension seuil de la diode Schottky ou de la diode au silicium correspondant approximativement à la moitié de la tension de saturation des photodiodes.

6. Circuit selon la revendication 5, caractérisé en ce que la diode Schottky (13) ou la diode au silicium est montée en série avec une résistance (14).

7. Circuit selon la revendication 2, caractérisé en ce que, en tant que résistance à auto-régulation, il est monté en parallèle à au moins une photodiode (10) un transistor à effet de champ (15) ou un transistor bipolaire, dont la résistance est réglée par un amplificateur opérationnel (16).

8. Circuit selon la revendication 2, caractérisé en ce qu'un amplificateur opérationnel symétrique (17) est raccordé à la ou aux photodiodes (10 ; 10'; 10") et à la résistance à auto-régulation.

9. Circuit selon la revendication 2, caractérisé en ce que pour la régulation du courant de photodiode, il est monté en série entre deux photodiodes (10', 10") de même polarité un transistor à effet de champ (18) qui peut être réglé par l'intermédiaire d'un amplificateur opérationnel (19) monté en parallèle et en amont duquel des résistances (20, 21) sont montées aux deux entrées, pour compenser la tension photoélectrique.

10. Circuit selon la revendication 1, caractérisé en ce que l'élément optoélectronique pour la réception des signaux lumineux est une diode électroluminescente (110).

11. Circuit selon la revendication 10, caractérisé en ce qu'un transistor bipolaire (113) est monté en parallèle à la diode électroluminescente (110) en vue de sa sollicitation.
